# EUROPÄISCHE PATENTSCHRIFT

(11) **EP 2 350 928 B1**
(45) Veröffentlichungstag und Bekanntmachung des Hinweises auf die Patenterteilung: **06.08.2014**
(21) Anmeldenummer: 09749090.8
(22) Anmeldetag: 03.11.2009
(51) Int. Cl.: G06K 19/077, H01L 23/485

(54) **VERFAHREN ZUR HERSTELLUNG EINES RFID-TRANSPONDERPRODUKTS UND NACH DEM VERFAHREN HERGESTELLTES RFID-TRANSPONDERPRODUKT**
METHOD FOR PRODUCING AN RFID TRANSPONDER PRODUCT, AND RFID TRANSPONDER PRODUCT PRODUCED USING THE METHOD
PROCÉDÉ DE FABRICATION D UN PRODUIT DE TRANSPONDEUR RFID ET PRODUIT DE TRANSPONDEUR FABRIQUÉ SELON LE PROCÉDÉ

(30) Priorität: 03.11.2008 DE 102008055630
(43) Veröffentlichungstag der Anmeldung: 03.08.2011
(73) Patentinhaber: SMARTRAC TECHNOLOGY GmbH, 01099 Dresden (DE)
(72) Erfinder: WAGNER, Marco, 01169 Dresden (DE); PRESCHER, Henry, 01159 Dresden (DE)
(74) Vertreter: Adler, Peter
(86) Internationale Anmeldenummer: PCT/EP2009/064548
(87) Internationale Veröffentlichungsnummer: WO 2010/060755

(56) Entgegenhaltungen:
- EP-A2- 0 706 152
- WO-A1-2004/093002
- WO-A2-2008/012416
- US-A1- 2005 134 463

## Beschreibung

Die Erfindung betrifft ein Verfahren zur Herstellung eines RFID-Transponderprodukts und nach dem Verfahren hergestelltes RFID-Transponderprodukte. Unter einem RFID-Transponderprodukt soll dabei eine Schaltungsanordnung mit mindestens einer Transponderantenne und mindestens einem mit der Transponderantenne (nachfolgend auch als Antennenstruktur bezeichnet) verbundenen integrierten Schaltkreis (nachfolgend auch als Chip bezeichnet) verstanden werden, die zum drahtlosen Datenaustausch mit entsprechenden Lesegeräten ausgebildet ist. Typische Beispiele für solche flächigen RFID-Transponderprodukte sind kontaktlose Chipkarten, Identifikationsdokumente, Eintrittskarten, Fahrausweise usw., aber auch Vorlaminate, die später zu den zuerst genannten Endprodukten weiterverarbeitet werden.

RFID-Transponderprodukte können starken mechanischen Beanspruchungen unterliegen, die insbesondere hohe Anforderungen an die Integration des Chips in das Produkt sowie an seine elektrische Verbindung zur Transponderantenne stellen. Diese Beanspruchungen können sowohl im Herstellungsprozess, beispielsweise beim Laminieren mehrerer Lagen miteinander, als auch beim Einsatz der Produkte entstehen.

Aus diesem Grunde werden vorzugsweise Chips in gekapselter Bauform eingesetzt, bei der der Chip in einem separaten Gehäuse angeordnet ist. Damit ist für die ID Dokumente oder deren Vorprodukte eine Aufbaudicke gegeben, welche wesentlich durch die Dicke des gehausten Chips bestimmt wird. Ein Beispiel hierfür sind die insbesondere bei einigen Chipkartentypen gebräuchlichen Chipmodule, bei denen die Kontaktierung des Chips indirekt über einen weiteren Hilfsträger, z.B. einen sogenannten Leadframe erfolgt. Dabei wird der Chip zunächst mit der Die-Bond-Technik auf dem Leadframe befestigt und anschließend die Anschlussflächen des Chips mit der Draht-Bond-Technik mit dem Leadframe verbunden. Danach wird das Leadframe mit dem Chip mit Epoxidharz vergossen. Die Kontaktierung des Chips in einer Schaltungsanordnung erfolg dadurch, dass die freiliegenden Anschlüsse des Leadframes kontaktiert werden.

Die Chips in gekapselter Bauform werden vorzugsweise mit den Enden einer aus mehreren Windungen bestehenden Drahtantenne verbunden und damit das eigentliche RFID Element ausgebildet. Beispielhaft wird eine derartige Anordnung in WO 2008/058616 A1 ausgeführt.

Die Verarbeitung von Nacktchips, d.h. Chips, welche nicht in einem eigenen Gehäuse angeordnet sind, ermöglicht eine deutliche Reduzierung dieser Aufbauhöhe der Produkte einerseits, vergrößert aber andererseits die Gefahr eines Bruchs des Chips oder/und der Beschädigung der Kontaktierung des Chips.

Werden anstelle von gelegten Drahtantennen, zum Beispiel bestehend aus mehreren Windungen von isoliertem Kupferdraht, flächig ausgeführte Antennenstrukturen eingesetzt, dann ist eine Konstruktion erforderlich , bei welcher eine oder mehrere Antennenwindungen überbrückt werden können. Unter Verwendung dieser Brückenkonstruktion wird das eine Ende der Antennenstruktur mit einem ersten Anschluss des RFID-Chips verbunden. Ein zweiter Anschluss des RFID-Chips wird direkt mit dem anderen Ende der Antennenstruktur verbunden.

Dem Stand der Technik nach sind zur Realisierung der notwendigen elektrisch leitenden Brücke verschiedene konstruktive Varianten bekannt, welche technologisch stets die Verwendung von zusätzlichem Kontaktwerkstoffmaterial bedingen.

So wird in DE 10 2007 054 692 A1 ein Aufbau für ein RFID-Inlay beschrieben, bei dem verschiedene Antennenabschnitte auf gegenüberliegenden Substratseiten eines Trägers angeordnet sind. Im Substrat befindet sich wenigstens eine Durchgangsöffnung, mit deren Hilfe während des Metallisierens eine elektrisch leitende Verbindung zwischen den auf gegenüberliegenden Substratseiten angeordneten Antennenabschnitten hergestellt wird.

In EP 1 433 368 A1 wird ein Aufbau dargestellt, bei dem eine Zunge der innenliegenden Leiterbahn durch zwei Einschnitte hindurch auf der anderen Substratseite entlang verlegt wird, so dass die zu kreuzenden Windungen durch das Substratmaterial gegenüber der Zunge isoliert werden.

Die WO 01/39114 A1 beschreibt einen Aufbau, bei dem ein Isolierlackmaterial zwischen den Anschlusspunkten der Brücke durch Siebdruck aufgebracht wird. Das Aufbringen der Brücke erfolgt ebenfalls durch Siebdruck einer leitenden Lackschicht. Anschließend erfolgt das Aufbringen einer Schutzschicht aus isolierendem Material ebenfalls durch Siebdruck.

In WO 98/011507 A1 wird ein Aufbau beschrieben, bei dem eine Antenne durch Drucken einer leitfähigen Tinte, eine Isolierung durch Drucken eines Dielektrikums und eine Brücke durch Drucken ebenfalls einer leitfähigen Tinte erzeugt wird.

Ein weiteres Beispiel für die Ausbildung der Brückenkonstruktion wird in EP 1 742 173 A2 offenbart. In einem mehrlagigen Kartenaufbau befindet sich die Struktur einer Antennenspule auf einer Trägerlage, die eine Aussparung aufweist, welche den unteren Teil des Chipmoduls, d.h. den gehausten Chip, aufnimmt. Über der Trägerlage wird eine Kompensationslage aufgebracht, welche eine Aussparung zur Aufnahme des oberen Teils des Chipmoduls, d.h. den d.h. dem Hilfsträger dient. Weitere Aussparungen sind zur Ausbildung der Antennenbrücke vorgesehen.

Zunächst wird die Antennenstruktur auf die Trägerlage gebracht, dann die Kompensationslage auflaminiert, das Chipmodul mit dem gehausten Chip auf die Antennenstruktur aufgesetzt und auf die Kompensationslage die Brücke gedruckt, wobei alle Schritte im Bogenformat ausgeführt werden. Die elektrisch leitende Brücke ist direkt auf die Oberseite der Kompensationslage aufgebracht, z.B. durch Drucken einer leitenden Paste. Die Paste wird dabei auf die Oberseite der Kompensationslage und dabei auch über die Öffnungen gedruckt.

In US 2005/0134463 A1 ist ein Transponderprodukt beschrieben, bei dem entweder ein zweischichtiger Aufbau von Trägerlagen verwendet wird, die miteinander laminiert sind, oder ein zweischichtiger Aufbau von Trägerlagen verwendet wird, die durch ein Harz miteinander verklebt sind.

Es besteht daher ein Bedarf an verbesserten RFID-Transponderprodukten sowie an verbesserten Verfahren zur Herstellung solcher RFID-Transponderprodukte, bei denen die auf den Chip und seine Kontaktstellen wirkenden Spannungen reduziert werden können. Ziel der Erfindung ist es, eine konstruktive Anordnung zu entwickeln, welche einerseits den Nacktchip innerhalb des Lagenaufbaus gegen mechanische Belastungen schützt, eine technisch einfache Konstruktion zur Realisierung des Brückenaufbaus ermöglicht und andererseits einen sehr produktiven Herstellungsprozess unter Nutzung von Rolle-zu-Rolle-Technologien erlaubt.

Diese Aufgaben werden gelöst durch ein Verfahren mit den Merkmalen des Patentanspruchs 1 sowie ein RFID-Transponderprodukt mit den Merkmalen des Patentanspruchs 11. Vorteilhafte Ausgestaltungen und Weiterbildungen sind in den abhängigen Ansprüchen beschrieben.

Vorgeschlagen wird daher ein Verfahren zur Herstellung eines RFID-Transponderprodukts, welches die folgenden Schritte umfasst:
1. Erzeugen einer kreuzungsfreien spulenförmigen Antennenstruktur mit einem Chipterminal und einem Brückenterminal sowie einer Verbindungsstruktur mit einem Chipterminal und einem Brückenterminal auf einer nichtleitenden Trägerlage mit aussparungsfreier Oberfläche.
2. Kontaktierung eines Nacktchips mit den Chipterminals von Antennenstruktur und Verbindungsstruktur in Flip-Chip-Technik.
3. Erzeugen einer Einbettungsöffnung entsprechend der Größe und Lage des Nacktchips sowie zweier Durchkontaktierungsöffnungen entsprechend der Lage der Brückenterminals in einer nichtleitenden Ausgleichslage.
4. Erzeugen einer Brückenstruktur mit zwei Anschlussterminals auf einer nichtleitenden Decklage.
5. Positionieren der Ausgleichslage über der Trägerlage so, dass der Nacktchip in der Einbettungsöffnung der Ausgleichslage angeordnet ist und die Durchkontaktierungsöffnungen über den Brückenterminals von Antennenstruktur und Verbindungsstruktur angeordnet sind, und Positionieren der Decklage über der Ausgleichslage so, dass die Anschlussterminals über den Durchkontaktierungsöffnungen der Ausgleichslage angeordnet sind.
6. Verbinden der Trägerlage, Ausgleichslage und Decklage miteinander durch Laminieren.

Für den Fachmann versteht sich dabei von selbst, dass insbesondere die Verfahrensschritte, die an unterschiedlichen Lagen durchzuführen sind, teilweise parallel, d.h. zeitgleich ausgeführt werden können. Insofern soll durch die Nummerierung keine zwingend einzuhaltende Reihenfolge suggeriert werden; vielmehr dient die gewählte Nummerierung nur der Vereinfachung der Referenz zu einem bestimmten Schritt. Beispielsweise können die an der Trägerlage durchzuführenden Schritte 1 oder/und 2 ausgeführt werden, während gleichzeitig an der Ausgleichslage der Schritt 3 ausgeführt wird oder/und während gleichzeitig an der Decklage der Schritt 4 ausgeführt wird. In gleicher Weise können die Schritte 5 und 6 quasi gleichzeitig erfolgen, wie nachfolgend noch am Beispiel eines vorteilhaften Rolle-zu-Rolle-Verfahrens erläutert wird.

Durch das beschriebene Verfahren können RFID-Transponderprodukte mit höherer Robustheit gegenüber äußeren mechanischen Belastungen hergestellt werden, wobei die Herstellung einfach und kostengünstig gegenüber bekannten Verfahren erfolgt. Gleichzeitig ist es auf einfachere Weise als bisher möglich, eine leitende Brückenstruktur elektrisch isoliert über eine leitende spulenförmige Antennenstruktur zu führen.

Das beschriebene Verfahren führt damit zur Herstellung einer Anordnung, die beispielsweise zu einer kontaktlosen Chipkarte oder einem Identifikationsdokument weiterverarbeitet werden kann und die einen mehrlagigen Aufbau aufweist, wobei ein erster Teil einer RFID-Antenne, der zumindest eine spulenförmige Antennenstruktur und eine Verbindungsstruktur umfasst, auf einer ersten isolierenden Lage, der Trägerlage, angeordnet ist und auf diesen Teil der Antennenstruktur der Chip direkt montiert und kontaktiert ist, darüber eine isolierende Zwischenlage, die Ausgleichslage, angeordnet ist, welche im Bereich des Chips eine erste Aussparung entsprechend der Chipgröße , die Einbettungsöffnung, aufweist, und welche mindestens zwei zweite Aussparungen, die Durchkontaktierungsöffnungen, im Kreuzungsbereich des ersten Teils der RFID-Antenne mit dem zweiten Teil der RFID-Antenne, der Brückenstruktur, aufweist, die sich auf einer weiteren Lage, der Decklage, befindet, und in Folge der Laminierung die einzelnen Schichten miteinander verbunden sind.

Mit anderen Worten erhält man durch das beschriebene Verfahren eine Anordnung, die eine erste Lage (Trägerlage) mit einem ersten Teil einer RFID-Antenne und dem darauf montiertem Chip, eine Zwischenlage (Ausgleichslage) aus isolierendem Material mit einer Aussparung für den Chip (Einbettungsöffnung) und mindestens zwei Löchern (Durchkontaktierungsöffnungen) und eine obere Lage (Decklage) mit einer darauf aufgebrachten leitenden Brückenstruktur umfasst, wobei bei der Laminierung, durch den Druck und die Wahl der Dicke der Isolierlage (Ausgleichslage) die leitenden Schichten der unteren Antennenstruktur und Verbindungsstruktur und der oberen Brückenstruktur zueinander gedrückt und partiell verformt werden und dadurch einen dauernden Kontakt ausbilden. Durch die Zwischenlage (Ausgleichslage) wird während der Laminierung der Chip geschützt.

Nochmals anders ausgedrückt wird durch das beschriebene Verfahren eine Anordnung hergestellt, die einen mehrlagigen Aufbau umfasst, bei dem ein erster Teil der RFID-Antenne (Antennenstruktur und Verbindungsstruktur) auf einer ersten Lage (Trägerlage) angeordnet und direkt mit einem Nacktchip verbunden ist, darüber eine isolierende zweite Lage (Ausgleichslage) angeordnet ist mit mindestens einer Aussparung (Durchkontaktierungsöffnung) im Bereich der Antennenstruktur und der Verbindungsstruktur zur Ausbildung eines elektrisches Kontaktes zu einem zweiten Teil der Antennenstruktur (Brückenstruktur), und mit einer Aussparung (Einbettungsöffnung) im Bereich des Chips, sowie einer darauf angeordneten dritten Lage (Decklage) mit einem zweiten Teil der RFID-Antenne (Brückenstruktur), welcher sich dann im Prozess der Laminierung der Lagen mit dem ersten Teil der RFID-Antenne verbindet.

Die Materialien von Trägerlage, Ausgleichslage und Decklage können beispielsweise Kunststofffolien gefüllt oder ungefüllt, aber auch Papier, Pappe, Vlies, textile Materialien oder Gewebe sein. Dabei müssen nicht alle Lagen aus demselben Werkstoff bestehen. Beispielsweise kann die Ausgleichslage eine Kunststofffolie sein, während Trägerlage und Decklage aus Papier bestehen. Umgekehrt sind auch Kombinationen möglich, bei denen die Ausgleichslage aus Papier besteht, während Trägerlage und Decklage Kunststofffolien sind.

Das Verfahren kann weiterhin dadurch gekennzeichnet sein, dass die Antennenstruktur oder/und die Verbindungsstruktur oder/und die Brückenstruktur durch Druckverfahren hergestellt werden. Solche Druckverfahren sind beispielsweise Siebdruck, Schablonendruck, Tampondruck, Offsetdruck, Inkjet oder andere geeignete Verfahren, bei denen leitfähige Tinten, leitfähige Polymere, Druckpasten, Materialien mit anorganischen oder organischen leitenden Partikeln, Nanopartikeln usw. oder ähnliche Materialien verwendet werden, um leitfähige Strukturen zu erzeugen. Alternativ können die Antennenstruktur oder/und die Verbindungsstruktur oder/und die Brückenstruktur (letztere zumindest teilweise) durch subtraktive Verfahren, beispielsweise selektives Ätzen hergestellt werden. In diesem Fall kann die größere Dicke der Anschlussterminals der Brückenstruktur dadurch hergestellt werden, dass an den Enden eines durch Ätzen erzeugten Leiterzugs selektiv leitendes Material aufgetragen wird, was wiederum durch Drucken geschehen kann.

Dabei kann vorgesehen sein, dass die Anschlussterminals der Brückenstruktur mit einer größeren Dicke hergestellt werden als der Rest der Brückenstruktur oder/und dass die Brückenterminals von Antennenstruktur und Verbindungsstruktur mit einer größeren Dicke hergestellt werden als der Rest der Antennenstruktur bzw. Verbindungsstruktur. Die so verdickten Terminals erleichtern die sichere Herstellung eines elektrischen Kontakts durch die Durchkontaktierungsöffnungen.

Weiterhin kann vorgesehen sein, dass zwei Ausgleichslagen übereinander angeordnet werden, wovon in der unteren Ausgleichslage die Einbettungsöffnung und Durchkontaktierungsöffnungen und in der oberen Ausgleichslage nur Durchkontaktierungsöffnungen erzeugt werden. Die obere Ausgleichslage deckt damit auch den Nacktchip ab.

In einer Ausgestaltung des Verfahrens kann vorgesehen sein, dass der Nacktchip durch einen Klebstoff mit den Chipterminals der Antennenstruktur und Verbindungsstruktur kontaktiert wird. Diese Ausgestaltung hat Vorteile gegenüber Lötverfahren, die dennoch möglich sind und von der Erfindung mit umfasst sein sollen. Alternativ kann vorgesehen sein, dass der Nacktchip direkt auf die noch nicht vollständig ausgehärteten Chipterminals von Antennenstruktur und Verbindungsstruktur aufgesetzt wird, so dass zusätzlicher Klebstoff nicht benötigt wird.

Nach einer anderen Ausgestaltung des Verfahrens ist vorgesehen, dass in einem Rolle-zu-Rolle-Prozess eine Vielzahl zusammenhängender RFID-Transponderprodukte hergestellt werden, die anschließend vereinzelt werden. Dabei können die Ausgangsmaterialien von Trägerlage, Ausgleichslage und Decklage jeweils in Rolle-zu-Rolle-Prozessen bereitgestellt werden. Die Materialien werden gleichzeitig abgerollt und daran die entsprechenden Verfahrensschritte durchgeführt. In einem letzten Schritt erfolgt das Laminieren der verschiedenen Lagen, wobei die Lagen als Rollenware, als Bogenware oder in deren Kombination beigestellt werden. Damit entstehen eine Vielzahl gleichartiger Anordnungen, die entweder sofort, beispielsweise durch Schneiden oder Stanzen, vereinzelt werden können. Alternativ kann die Laminatbahn zunächst aufgewickelt werden und die Vereinzelung zu einem späteren Zeitpunkt durchgeführt werden.

Das durch das Verfahren hergestellte RFID-Transponderprodukt kann anschließend mindestens einseitig mit einer weiteren Lage verbunden werden. Auf diese Weise lassen sich beispielsweise selbstklebende RFID-Etiketten herstellen. Die weiteren Lagen können dabei aus einem Fasermaterial wie Papier, Pappe, Vlies, textile Materialien oder Gewebe sein und ein- oder beidseitig auf das RFID-Transponderprodukt geklebt werden. Alternativ kann das RFID-Transponderprodukt zwischen zwei weiteren Lagen aus einem Kunststoffmaterial eingebracht werden, wodurch beispielsweise Kreditkarten, Zugangskontrollkarten und ähnliche Produkte hergestellt werden können.

Das vorgeschlagene RFID-Transponderprodukt, das eine höhere Robustheit gegenüber mechanischen Belastungen aufweist, umfasst eine nichtleitende Trägerlage, eine separate, nichtleitende Ausgleichslage aus Kunststofffolie, Papier, Pappe, Vlies, textilem Material oder Gewebe, und mindestens eine nichtleitende Decklage, die zusammenlaminiert sind, wobei auf der Trägerlage eine kreuzungsfreie spulenförmige Antennenstruktur mit einem Chipterminal und einem Brückenterminal, eine Verbindungsstruktur mit einem Chipterminal und einem Brückenterminal sowie ein mit den Chipterminals von Antennenstruktur und Verbindungsstruktur in Flip-Chip-Technik kontaktierter Nacktchip angeordnet sind, in der Ausgleichslage eine Einbettungsöffnung entsprechend der Größe und Lage des Nacktchips sowie mindestens zwei Durchkontaktierungsöffnungen entsprechend der Lage der Brückenterminals angeordnet sind, auf der Decklage eine Brückenstruktur mit zwei Anschlussterminals angeordnet ist, die eine größere Dicke aufweisen als der Rest der Brückenstruktur, und Trägerlage, Ausgleichslage und Decklage so zueinander angeordnet sind, dass der Nacktchip in der Einbettungsöffnung der Ausgleichslage angeordnet ist, die Durchkontaktierungsöffnungen über den Brückenterminals von Antennenstruktur und Verbindungsstruktur angeordnet sind, die Anschlussterminals über den Durchkontaktierungsöffnungen der Ausgleichslage angeordnet sind und die Anschlussterminals der Brückenstruktur mit den Brückenterminals von Antennenstruktur und Verbindungsstruktur elektrisch leitend verbunden sind.

Nachfolgend soll ein Ausführungsbeispiel des vorgeschlagenen RFID-Transponderprodukts anhand von Zeichnungsfiguren näher erläutert werden. Dabei zeigen
Fig. 1 die Trägerlage, Ausgleichslage und Decklage, und
Fig. 2 einen Querschnitt durch alle drei Lagen unmittelbar vor dem Laminieren.

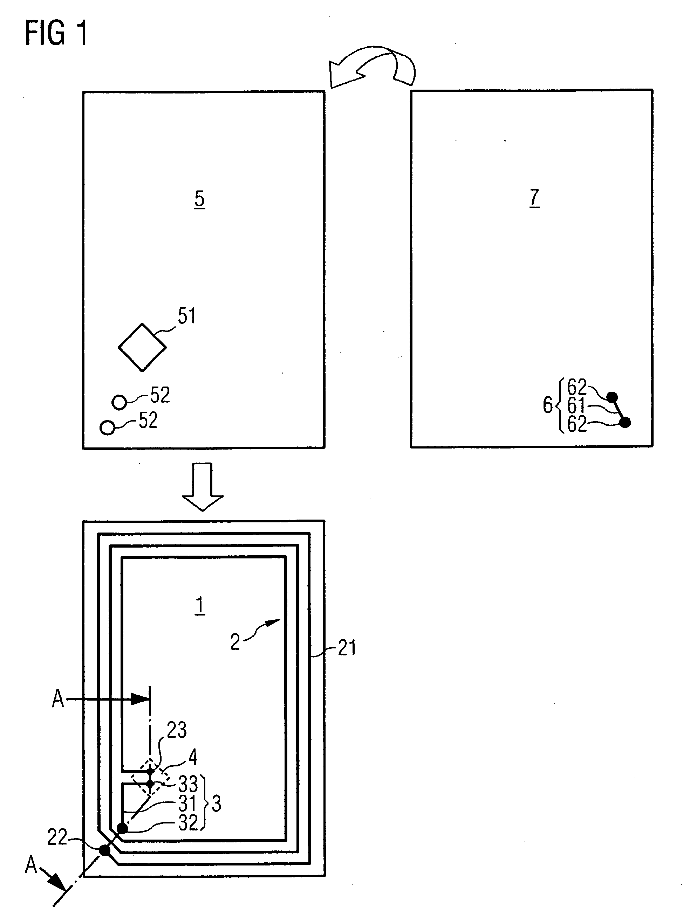

In Fig. 1 sind eine Trägerlage 1, eine Ausgleichslage 5 und eine Decklage 7 dargestellt. Auf der Trägerlage 1 mit geschlossener Oberfläche sind eine kreuzungsfreie spulenförmige Antennenstruktur 2 mit Spulenwindungen 21, einem Chipterminal 23 und einem Brückenterminal 22 sowie eine Verbindungsstruktur 3 mit einem Leiterzug 31, einem Chipterminal 33 und einem Brückenterminal 32 angeordnet.

Auf die Chipterminals 23, 33 von Antennenstruktur 2 und Verbindungsstruktur 3 ist ein Nacktchip 4 in Flip-Chip-Technik aufgesetzt und kontaktiert.

Auf der Decklage 7 ist eine Brückenstruktur 6 mit zwei Anschlussterminals 62 angeordnet, wobei die Anschlussterminals 62 der Brückenstruktur 6 eine größere Dicke aufweisen können als der zwischen ihnen verlaufende Leiterzug 61. Die Decklage 7 ist über Kopf dargestellt, daher scheint die Anordnung der Brückenstruktur 6 spiegelverkehrt im Vergleich mit der Anordnung der Durchkontaktierungsöffnungen 52 auf der Ausgleichslage 5 und den Brückenterminals 22, 32 von Antennenstruktur 2 und Verbindungsstruktur 3.

In der Ausgleichslage 5 sind eine Einbettungsöffnung 51 entsprechend der Größe und Lage des Nacktchips 4 sowie zwei Durchkontaktierungsöffnungen 52 entsprechend der Lage der Brückenterminals 62 der Brückenstruktur 6 angeordnet.

Vor dem Laminieren der drei Lagen 1, 5, 7 müssen diese relativ zueinander so ausgerichtet werden, dass sich die Brückenterminals 22, 32 von Antennenstruktur 2 und Verbindungsstruktur 3 auf der Trägerlage 1, die Durchkontaktierungsöffnungen 52 der Ausgleichslage 5 und die Anschlussterminals 62 der Brückenstruktur 6 auf der Decklage 7 deckungsgleich übereinander befinden. Wenn dies erreicht ist, befindet sich auch die Einbettungsöffnung 51 der Ausgleichslage 5 deckungsgleich über dem Nacktchip 4 auf der Trägerlage 1. Nach dem Laminieren steht ein RFID-Transponderprodukt zur Verfügung, das eine homogene Dicke aufweist und entweder direkt verwendet oder zu weiteren Produkten weiterverarbeitet werden kann.

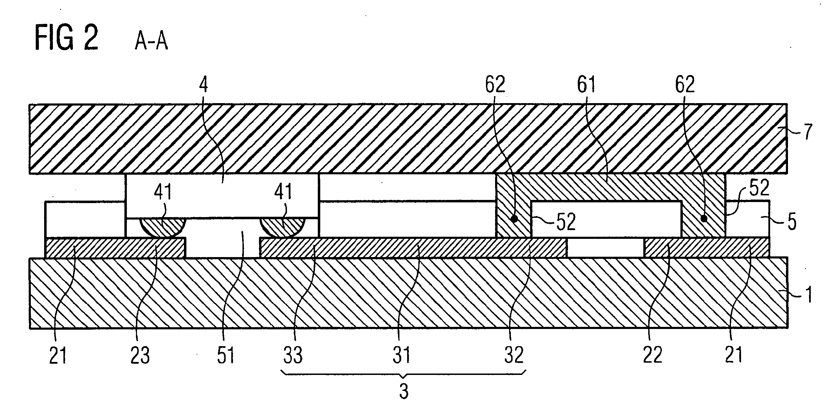

Fig. 2 zeigt einen Querschnitt durch die drei Lagen 1, 5, 7 unmittelbar vor dem Laminieren. Die Trägerlage 1 trägt die Antennenstruktur 2 mit einem Brückenterminal 22 und einem Chipterminal 23 und die Verbindungsstruktur 3 mit einem Brückenterminal 32 und einem Chipterminal 33. Auf den Chipterminals 23, 33 ist ein Nacktchip 4 in Flip-Chip-Technik montiert. An der Unterseite des Nacktchips 4 befinden sich hierzu Kontaktierungsmittel 41, die als sogenannte Bumps oder als Klebstoff ausgeführt sein können. Auf der Trägerlage 1 und der darauf befindlichen Antennenstruktur 2 ist eine isolierende Ausgleichslage 5 mit einer Einbettungsöffnung 51 für den Chip 4 und mit zwei Durchkontaktierungsöffnungen 52 für die Anschlussterminals 62 der Brückenstruktur 6 angeordnet. Der zur Brückenstruktur 6 gehörende Leiterzug 61 ist auf der Unterseite der Decklage 7 angeordnet. Diese Decklage 7, die nach außen geschlossen ist und dadurch die Antennenstruktur 2, die Brückenstruktur 6 und den Chip 4 vor mechanischen Beanspruchungen schützt, wird mit der Trägerlage 1 und den darauf angeordneten weiteren Komponenten, insbesondere der Ausgleichslage 5, laminiert, so dass sich ein widerstandsfähiger Aufbau ergibt. Durch das Laminieren verbinden sich die Komponenten des RFID-Transponderprodukts stofflich, so dass die in Fig. 2 sichtbaren Zwischenräume nicht mehr vorhanden sind.

Die Antennenstrukturen sind im Ausführungsbeispiel aus elektrisch leitenden polymeren Pasten hergestellt. Die Schichtdicke der polymeren Pasten und das sich durch den Druck- und Härteprozess einstellende Oberflächenrelief der Pasten, sowie die Wahl des Pastenmaterials und die Dicke der isolierenden Ausgleichslage 5 sind die notwendige Voraussetzungen für die Ausbildung der Kontakte zwischen den Brückenterminals 22, 32 der Antennenstruktur 2 und der Verbindungsstruktur 3 einerseits und den Anschlussterminals 62 der Brückenstruktur 6. Die Brückenstruktur 6 kann auch in mehreren und aufeinander folgenden Druckschritten derart hergestellt werden, dass die Oberfläche im Bereich der sich auszubildenden Kontaktstellen Erhebungen aufweist. Alternativ oder zusätzlich zu den Erhebungen auf den Anschlussterminals 62 der Brückenstruktur 6 können Erhebungen auch auf den Brückenterminals 22 und 32 von Antennenstruktur 2 und Verbindungsstruktur 3, d.h. auf der Trägerlage 1 aufgebracht sein.

Der konstruktive Aufbau ist dabei so ausgeführt, dass alle zur Herstellung der Antennen-, Kontaktierungs- und Brückenstrukturen 2, 3, 6 notwendigen Druckschritte in hochproduktiven Rolle-zu-Rolle-Verfahren möglich sind und die einzelnen Lagen unabhängig voneinander gefertigt werden können. Auch die Montage des Nacktchips 4 auf die Trägerlage 1 kann ohne Einschränkungen in Rolle-zu-Rolle-Technologie erfolgen.

Alternativ sind auch Antennen-, Kontaktierungs- und Brückenstrukturen 2, 3, 6 einsetzbar, welche mittels metallischen Abscheideverfahren oder selektiven Metallabtragverfahren erzeugt worden sind. Ein weiterer Vorteil der flächig erzeugten Antennen-, Kontaktierungs- und Brückenstrukturen 2, 3, 6 besteht in der Möglichkeit der Ausbildung von separaten Kondensatorstrukturen. Vorteilhaft dient hierbei die isolierende Ausgleichslage 5 als dielektrisch wirkende Schicht mit einer durch ihre genaue Dicke reproduzierbar einstellbaren Kapazität.

Die Erfindung hat verfahrenstechnisch den Vorteil, dass die Brückenstruktur 6 auf die Decklage 7 gedruckt wird. Somit können alle Lagen 1, 5, 7 separat und unabhängig voneinander hergestellt werden. Außerdem kann das Drucken der Brückenstruktur 6 ebenfalls im Rolle-zu-Rolle-Prozess erfolgen. Das Fügen der drei Lagen 1, 5, 7 erfolgt in einem letzten Arbeitsschritt.

## Patentansprüche

1. Verfahren zur Herstellung eines RFID-Transponderprodukts, umfassend die Schritte
a. Erzeugen einer kreuzungsfreien spulenförmigen Antennenstruktur (2) mit einem Chipterminal (23) und einem Brückenterminal (22) sowie einer Verbindungsstruktur (3) mit einem Chipterminal (33) und einem Brückenterminal (32) auf einer nichtleitenden Trägerlage (1) mit aussparungsfreier Oberfläche,
b. Kontaktierung eines Nacktchips (4) mit den Chipterminals (23, 33) von Antennenstruktur (2) und Verbindungsstruktur (3) in Flip-Chip-Technik,
c. Erzeugen einer Einbettungsöffnung (51) entsprechend der Größe und Lage des Nacktchips (4) sowie zweier Durchkontaktierungsöffnungen (52) entsprechend der Lage der Brückenterminals (22, 32) in mindestens einer separaten, nichtleitenden Ausgleichslage (5) aus Kunststofffolie, Papier, Pappe, Vlies, textilem Material oder Gewebe,
d. Erzeugen einer Brückenstruktur (6) mit mindestens zwei Anschlussterminals (62) auf einer nichtleitenden Decklage (7),
e. Positionieren der Ausgleichslage (5) über der Trägerlage (1) so, dass der Nacktchip (4) in der Einbettungsöffnung (51) der Ausgleichslage (5) angeordnet ist und die Durchkontaktierungsöffnungen (52) über den Brückenterminals (22, 32) von Antennenstruktur (2) und Verbindungsstruktur (3) angeordnet sind, und Positionieren der Decklage (7) über der Ausgleichslage (5) so, dass die Anschlussterminals (62) über den Durchkontaktierungsöffnungen (52) der Ausgleichslage (5) angeordnet sind,
f. Verbinden der Trägerlage (1), Ausgleichslage (5) und Decklage (7) miteinander durch Laminieren.

2. Verfahren nach Anspruch 1, **dadurch gekennzeichnet, dass** Antennenstruktur (2), Verbindungsstruktur (3) und Brückenstruktur (6) durch Druckverfahren hergestellt werden.

3. Verfahren nach Anspruch 1 oder 2, **dadurch gekennzeichnet, dass** die Anschlussterminals (62) der Brückenstruktur (6) mit einer größeren Dicke hergestellt werden als der Rest der Brückenstruktur (6).

4. Verfahren nach einem der Ansprüche 1 bis 3, **dadurch gekennzeichnet, dass** die Brückenterminals (22, 32) von Antennenstruktur (2) und Verbindungsstruktur (3) mit einer größeren Dicke hergestellt werden als der Rest der Antennenstruktur (2) bzw. Verbindungsstruktur (3).

5. Verfahren nach einem der Ansprüche 1 bis 4, **dadurch gekennzeichnet, dass** zwei Ausgleichslagen (5) übereinander angeordnet werden, wovon in der unteren Ausgleichslage (5) die Einbettungsöffnung (51) und Durchkontaktierungsöffnungen (52) und in der oberen Ausgleichslage (5) nur Durchkontaktierungsöffnungen (52) erzeugt werden.

6. Verfahren nach einem der Ansprüche 1 bis 5, **dadurch gekennzeichnet, dass** der Nacktchip (4) durch einen Klebstoff mit den Chipterminals (23, 33) kontaktiert wird.

7. Verfahren nach einem der Ansprüche 1 bis 6, **dadurch gekennzeichnet, dass** in einem Rolle-zu-Rolle-Prozess eine Vielzahl zusammenhängender RFID-Transponderprodukte hergestellt werden, die anschließend vereinzelt werden.

8. Verfahren nach einem der Ansprüche 1 bis 7, **dadurch gekennzeichnet, dass** das RFID-Transponderprodukt mindestens einseitig mit einer weiteren Lage verbunden wird.

9. Verfahren nach Anspruch 8, **dadurch gekennzeichnet, dass** das RFID-Transponderprodukt mit mindestens einer weiteren Lage aus einem Fasermaterial verklebt wird.

10. Verfahren nach Anspruch 8, **dadurch gekennzeichnet, dass** das RFID-Transponderprodukt zwischen zwei weiteren Lagen aus einem Kunststoffmaterial eingebracht wird.

11. RFID-Transponderprodukt, umfassend eine nichtleitende Trägerlage (1), eine separate, nichtleitende Ausgleichslage (5) aus Kunststofffolie, Papier, Pappe, Vlies, textilem Material oder Gewebe, und eine nichtleitende Decklage (7), die zusammenlaminiert sind, wobei
a. auf der Trägerlage (1) eine kreuzungsfreie spulenförmige Antennenstruktur (2) mit einem Chipterminal (23) und einem Brückenterminal (22), eine Verbindungsstruktur (3) mit einem Chipterminal (33) und einem Brückenterminal (32) sowie ein mit den Chipterminals (23, 33) von Antennenstruktur (2) und Verbindungsstruktur (3) in Flip-Chip-Technik kontaktierter Nacktchip (4) angeordnet sind,
b. in mindestens einer Ausgleichslage (5) eine Einbettungsöffnung (51) entsprechend der Größe und Lage des Nacktchips (4) sowie mindestens zwei Durchkontaktierungsöffnungen (52) entsprechend der Lage der Brückenterminals (22, 32) angeordnet sind,
c. auf der Decklage (7) eine Brückenstruktur (6) mit zwei Anschlussterminals (62) angeordnet ist, und
d. Trägerlage (1), Ausgleichslage (5) und Decklage (7) so zueinander angeordnet sind, dass der Nacktchip (4) in der Einbettungsöffnung (51) der Ausgleichslage (5) angeordnet ist, die Durchkontaktierungsöffnungen (52) über den Brückenterminals (22, 32) von Antennenstruktur (2) und Verbindungsstruktur (3) angeordnet sind, die Anschlussterminals (62) über den Durchkontaktierungsöffnungen (52) der Ausgleichslage (5) angeordnet sind und die Anschlussterminals (62) der Brückenstruktur (6) mit den Brückenterminals (22, 32) von Antennenstruktur (2) und Verbindungsstruktur (3) elektrisch leitend verbunden sind.

12. RFID-Transponderprodukt nach Anspruch 11, **dadurch gekennzeichnet, dass** Antennenstruktur (2), Verbindungsstruktur (3) und Brückenstruktur (6) gedruckt sind.

13. RFID-Transponderprodukt nach Anspruch 11 oder 12, **dadurch gekennzeichnet, dass** die Anschlussterminals (62) der Brückenstruktur (6) eine größere Dicke aufweisen als der Rest der Brückenstruktur (6).

14. RFID-Transponderprodukt nach einem der Ansprüche 11 bis 13, **dadurch gekennzeichnet, dass** die Brückenterminals (22, 32) von Antennenstruktur (2) und Verbindungsstruktur (3) eine größere Dicke aufweisen als der Rest der Antennenstruktur (2) bzw. Verbindungsstruktur (3).

15. RFID-Transponderprodukt nach einem der Ansprüche 11 bis 14, **dadurch gekennzeichnet, dass** zwei Ausgleichslagen (5) übereinander angeordnet sind, wovon die untere Ausgleichslage (5) die Einbettungsöffnung (51) und Durchkontaktierungsöffnungen (52) aufweist und die obere Ausgleichslage (5) nur Durchkontaktierungsöffnungen (52) aufweist.

16. RFID-Transponderprodukt nach einem der Ansprüche 11 bis 15, **dadurch gekennzeichnet, dass** der Nacktchip (4) durch einen Klebstoff mit den Chipterminals (23, 33) kontaktiert ist.

17. RFID-Transponderprodukt nach einem der Ansprüche 11 bis 16, **dadurch gekennzeichnet, dass** das RFID-Transponderprodukt mindestens einseitig mit einer weiteren Lage verbunden ist.

18. RFID-Transponderprodukt nach Anspruch 17, **dadurch gekennzeichnet, dass** das RFID-Transponderprodukt mit mindestens einer weiteren Lage aus einem Fasermaterial verklebt ist.

19. RFID-Transponderprodukt nach Anspruch 17, **dadurch gekennzeichnet, dass** das RFID-Transponderprodukt zwischen zwei weiteren Lagen aus einem Kunststoffmaterial eingebettet ist.

## Claims

1. Method for producing an RFID transponder product, comprising the steps of:
a. creating a non-intersecting coil-shaped antenna structure (2) with a chip terminal (23) and a bridge terminal (22) as well as a connecting structure (3) with a chip terminal (33) and a bridge terminal (32) on a non-conducting carrier layer (1) with an uninterrupted surface,
b. contacting a bare chip (4) with the chip terminals (23, 33) of the antenna structure (2) and the connecting structure (3) by the flip-chip technique,
c. creating an embedding opening (51) corresponding to the size and location of the bare chip (4) as well as two plated-through openings (52) corresponding to the location of the bridge terminals (22, 32) in at least one separate non-conducting compensating layer (5) made from plastics film, paper, paperboard, nonwoven fabric, textile material or woven fabric,
d. creating a bridge structure (6) with at least two connection terminals (62) on a non-conducting cover layer (7),
e. positioning the compensating layer (5) over the carrier layer (1) such that the bare chip (4) is arranged in the embedding opening (51) of the compensating layer (5) and the plated-through openings (52) are arranged over the bridge terminals (22, 32) of the antenna structure (2) and the connecting structure (3), and positioning the cover layer (7) over the compensating layer (5) such that the connection terminals (62) are arranged over the plated-through openings (52) of the compensating layer (5), and
f. connecting the carrier layer (1), the compensating layer (5) and the cover layer (7) to one another by lamination.

2. Method according to Claim 1, **characterized in that** the antenna structure (2), the connecting structure (3) and the bridge structure (6) are produced by printing methods.

3. Method according to Claim 1 or 2, **characterized in that** the connection terminals (62) of the bridge structure (6) are produced with a greater thickness than the remainder of the bridge structure (6).

4. Method according to one of Claims 1 to 3, **characterized in that** the bridge terminals (22, 32) of the antenna structure (2) and the connecting structure (3) are produced with a greater thickness than the remainder of the antenna structure (2) and the connecting structure (3).

5. Method according to one of Claims 1 to 4, **characterized in that** two compensating layers (5) are arranged one on top of the other, with the embedding opening (51) and plated-through openings (52) being created in the lower compensating layer (5) and only plated-through openings (52) being created in the upper compensating layer (5).

6. Method according to one of Claims 1 to 5, **characterized in that** the bare chip (4) is contacted with the chip terminals (23, 33) by an adhesive.

7. Method according to one of Claims 1 to 6, **characterized in that** a multiplicity of contiguous RFID transponder products are produced in a roll-to-roll process and are subsequently individually separated.

8. Method according to one of Claims 1 to 7, **characterized in that** the RFID transponder product is connected at least on one side to a further layer.

9. Method according to Claim 8, **characterized in that** the RFID transponder product is adhesively bonded to at least one further layer made from a fibrous material.

10. Method according to Claim 8, **characterized in that** the RFID transponder product is inserted between two further layers made from a plastics material.

11. RFID transponder product comprising a non-conducting carrier layer (1), a separate, non-conducting compensating layer (5) made from plastics film, paper, paperboard, nonwoven fabric, textile material or woven fabric, and a non-conducting cover layer (7), which are laminated together, wherein
a. a non-intersecting coil-shaped antenna structure (2) with a chip terminal (23) and a bridge terminal (22), a connecting structure (3) with a chip terminal (33) and a bridge terminal (32), as well as a bare chip (4), contacted with the chip terminals (23, 33) of the antenna structure (2) and the connecting structure (3) by the flip-chip technique, are arranged on the carrier layer (1),
b. an embedding opening (51) corresponding to the size and location of the bare chip (4) as well as at least two plated-through openings (52) corresponding to the location of the bridge terminals (22, 32) are arranged in at least one compensating layer (5),
c. a bridge structure (6) with two connection terminals (62) is arranged on the cover layer (7), and
d. a carrier layer (1), a compensating layer (5) and a cover layer (7) are arranged in relation to one another such that the bare chip (4) is arranged in the embedding opening (51) of the compensating layer (5), the plated-through openings (52) are arranged over the bridge terminals (22, 32) of the antenna structure (2) and the connecting structure (3), the connection terminals (62) are arranged over the plated-through openings (52) of the compensating layer (5), and the connection terminals (62) of the bridge structure (6) are connected to the bridge terminals (22, 32) of the antenna structure (2) and the connecting structure (3) in an electrically conducting manner.

12. RFID transponder product according to Claim 11, **characterized in that** the antenna structure (2), the connecting structure (3) and the bridge structure (6) are printed.

13. RFID transponder product according to Claim 11 or 12, **characterized in that** the connection terminals (62) of the bridge structure (6) have a greater thickness than the remainder of the bridge structure (6).

14. RFID transponder product according to one of Claims 11 to 13, **characterized in that** the bridge terminals (22, 32) of the antenna structure (2) and the connecting structure (3) have a greater thickness than the remainder of the antenna structure (2) and the connecting structure (3).

15. RFID transponder product according to one of Claims 11 to 14, **characterized in that** two compensating layers (5) are arranged one on top of the other, with the lower compensating layer (5) having the embedding opening (51) and plated-through openings (52) and the upper compensating layer (5) having only plated-through openings (52).

16. RFID transponder product according to one of Claims 11 to 15, **characterized in that** the bare chip (4) is contacted with the chip terminals (23, 33) by an adhesive.

17. RFID transponder product according to one of Claims 11 to 16, **characterized in that** the RFID transponder product is connected at least on one side to a further layer.

18. RFID transponder product according to Claim 17, **characterized in that** the RFID transponder product is adhesively bonded to at least one further layer made from a fibrous material.

19. RFID transponder product according to Claim 17, **characterized in that** the RFID transponder product is embedded between two further layers made from a plastics material.

## Revendications

1. Procédé pour fabriquer un produit de transpondeur RFID comprenant les étapes suivantes
a. générer une structure d'antenne (2) sans croisement et en forme de bobine comportant un terminal de puce (23) et un terminal de pont (22) et une structure de liaison (3) avec un terminal de puce (33) et un terminal de pont (32) sur une couche de support (1) non conductrice avec surface sans évidement,
b. mettre en contact une puce nue (4) avec les terminaux de puce (23, 33) de la structure d'antenne (2) et de la structure de liaison (3) dans la technique de puce retournée,
c. générer une ouverture d'incorporation (51) en fonction de la grandeur et de la position de la puce nue (4) et deux ouvertures de contact traversant (52) en fonction de la position des terminaux de pont (22, 32) dans au moins une couche de compensation (5) séparée, non conductrice en feuille de matière plastique, en papier, en carton, en non-tissé, en matériau textile ou en tissu,
d. générer une structure de pont (6) avec au moins deux terminaux de raccordement (62) sur une couche de revêtement (7) non conductrice,
e. positionner la couche de compensation (5) au-dessus de la couche de support (1) de telle sorte que la puce nue (4) est disposée dans l'ouverture d'incorporation (51) de la couche de compensation (5) et les ouvertures de contact traversant (52) sont disposées au-dessus des terminaux de pont (22, 32) de la structure d'antenne (2) et de la structure de liaison (3), et positionner la couche de revêtement (7) au-dessus de la couche de compensation (5) de telle sorte que les terminaux de raccordement (62) sont disposés au-dessus des ouvertures de contact traversant (52) de la couche de compensation (5),
f. relier la couche de support (1), la couche de compensation (5) et la couche de revêtement (7) les unes aux autres par stratification.

2. Procédé selon la revendication 1, caractérisé en en ce que la structure d'antenne (2), la structure de liaison (3) et la structure de pont (6) sont fabriquées par procédé d'impression.

3. Procédé selon la revendication 1 ou 2, **caractérisé en ce que** les terminaux de raccordement (62) de la structure de pont (6) sont fabriqués avec une plus grande épaisseur que le reste de la structure de pont (6).

4. Procédé selon l'une quelconque des revendications 1 à 3, **caractérisé en ce que** les terminaux de pont (22, 32) de la structure d'antenne (2) et de la structure de liaison (3) sont fabriqués avec une plus grande épaisseur que le reste de la structure d'antenne (2), respectivement de la structure de liaison (3).

5. Procédé selon l'une quelconque des revendications 1 à 4, **caractérisé en ce que** deux couches de compensation (5) sont disposées l'une au-dessus de l'autre, l'ouverture d'incorporation (51) et des ouvertures de contact traversant (52) étant générées dans la couche de compensation inférieure (5) et seulement des ouvertures de contact traversant (52) étant générées dans la couche de compensation supérieure (5).

6. Procédé selon l'une quelconque des revendications 1 à 5, **caractérisé en ce que** la puce nue (4) est mise en contact avec les terminaux de puce (23, 33) par un adhésif.

7. Procédé selon l'une quelconque des revendications 1 à 6, **caractérisé en ce que** dans un procédé rouleau-sur-rouleau, une pluralité de produits de transpondeurs RFID rattachés sont fabriqués, lesquels sont ensuite séparés.

8. Procédé selon l'une quelconque des revendications 1 à 7, **caractérisé en ce que** le produit de transpondeur RFID est connecté au moins d'un côté à une couche supplémentaire.

9. Procédé selon la revendication 8, **caractérisé en ce que** le produit de transpondeur RFID est collé à au moins une couche supplémentaire en un matériau fibreux.

10. Procédé selon la revendication 8, **caractérisé en ce que** le produit de transpondeur RFID est introduit entre deux couches supplémentaires en matière plastique.

11. Produit de transpondeur RFID, comprenant une couche de support (1) non conductrice, une couche de compensation séparée non conductrice (5) en feuille de matière plastique, en papier, en carton, en non-tissé, en matériau textile ou en tissu, et une couche de revêtement (7) non conductrice, lesquelles sont stratifiées ensemble, dans lequel
a. on dispose sur la couche de support (1) une structure d'antenne (2) sans croisement et en forme de bobine, comportant un terminal de puce (23) et un terminal de pont (22) et une structure de liaison (3) avec un terminal de puce (33) et un terminal de pont (32) ainsi qu'une puce nue (4) mise en contact avec les terminaux de puce (23, 33) de la structure d'antenne (2) et de la structure de liaison (3) dans la technique de puce retournée,
b. on dispose dans au moins une couche de compensation (5) une ouverture d'incorporation (51) en fonction de la grandeur et de la position de la puce nue (4) ainsi qu'au moins deux ouvertures de contact traversant (52) en fonction de la position des terminaux de pont (22,32),
c. on dispose sur la couche de revêtement (7) une structure de pont (6) avec deux terminaux de raccordement (62), et
d. la couche de support (1), la couche de compensation (5) et la couche de revêtement (7) sont disposées les unes par rapport aux autres de telle sorte que la puce nue (4) soit disposée dans l'ouverture d'incorporation (51) de la couche de compensation (5), les ouvertures de contact traversant (52) soient disposées au-dessus des terminaux de pont (22, 32) de la structure d'antenne (2) et de la structure de liaison (3), les terminaux de raccordement (62) soient disposés au-dessus des ouvertures de contact traversant (52) de la couche de compensation (5) et les terminaux de raccordement (62) de la structure de pont (6) soient connectés électriquement aux terminaux de pont (22, 32) de la structure d'antenne (2) et de la structure de liaison (3).

12. Produit de transpondeur RFID selon la revendication 11, **caractérisé en ce que** la structure d'antenne (2), la structure de liaison (3) et la structure de pont (6) sont imprimées.

13. Produit de transpondeur RFID selon la revendication 11 ou 12, **caractérisé en ce que** les terminaux de raccordement (62) de la structure de pont (6) présentent une plus grande épaisseur que le reste de la structure de pont (6).

14. Produit de transpondeur RFID selon l'une quelconque des revendications 11 à 13, **caractérisé en ce que** les terminaux de pont (22, 32) de la structure d'antenne (2) et de la structure de liaison (3) sont fabriqués avec une plus grande épaisseur que le reste de la structure d'antenne (2), respectivement de la structure de liaison (3).

15. Produit de transpondeur RFID selon l'une quelconque des revendications 11 à 14, **caractérisé en ce que** deux couches de compensation (5) sont disposées l'une au-dessus de l'autre, la couche de compensation inférieure (5) présentant l'ouverture d'incorporation (51) et des ouvertures de contact traversant (52) et la couche de compensation supérieure (5) présentant seulement des ouvertures de contact traversant (52).

16. Produit de transpondeur RFID selon l'une quelconque des revendications 11 à 15, **caractérisé en ce que** la puce nue (4) est mise en contact avec les terminaux de puce (23, 33) par un adhésif.

17. Produit de transpondeur RFID selon l'une quelconque des revendications 11 à 16, **caractérisé en ce que** le produit de transpondeur RFID est connecté au moins d'un côté à une couche supplémentaire.

18. Produit de transpondeur RFID selon la revendication 17, **caractérisé en ce que** le produit de transpondeur RFID est collé à au moins une couche supplémentaire en un matériau fibreux.

19. Produit de transpondeur RFID selon la revendication 17, **caractérisé en ce que** le produit de transpondeur RFID est incorporé entre deux couches supplémentaires en matière plastique.
